# EUROPEAN PATENT APPLICATION

(11) **EP 4 610 299 A1**
(43) Date of publication of application: **03.09.2025**
(21) Application number: 25156071.0
(22) Date of filing: 05.02.2025
(51) Int. Cl.: C08J 7/044, C23C 14/20, H01B 7/282

(54) **WATER-BLOCKING BUFFER TAPE FOR CABLE AND METHOD FOR PREPARING THE SAME**

(30) Priority: 29.02.2024 CN 202410225809
(71) Applicant: GUANGZHOU POWER SUPPLY BUREAU OF GUANGDONG POWER GRID CO., LTD., Guangzhou, Guangdong 510620 (CN)
(72) Inventor: HUANG, Jiasheng, Guangzhou, 510620 (CN); LING, Ying, Guangzhou, 510620 (CN); LI, Meng, Guangzhou, 510620 (CN); HAN, Zhuozhan, Guangzhou, 510620 (CN)
(74) Representative: V.O.

(57) **Abstract**

The present application relates to a water-blocking buffer tape for a cable and a method for preparing the same. A water-blocking buffer tape for a cable includes a rubber substrate and a conductive metal film layer covering a surface of the rubber substrate; wherein the rubber substrate includes vulcanized butyl rubber and conductive carbon black dispersed in the vulcanized butyl rubber.

## Description

### TECHNICAL FIELD

The present application relates to the technical field of electrical materials, and in particular to a water-blocking buffer tape for a cable and a method for preparing the same.

### BACKGROUND

Buffer layer burning in high-voltage cables is a common problem in cable failures. The main reason is that the cable buffer layer comprises old-fashioned water-blocking buffer tape, which contains water-blocking powder. After absorbing moisture, the water-blocking buffer tape easily forms high-resistance crystalline substances at the place where it contacts the cable aluminum sheath. The high-resistance crystalline substances as white powders, mainly include Al₂O₃, Na₂CO₃, NaHCOs, etc., and will undergo electrochemical corrosion or electrolysis with corrugated aluminum in the outer layer under the action of an external electric field, causing the buffer layer of the high-voltage cable to be corroded. It is not conducive to the conduction of the cable and may even generate heat, causing temperature rise and leading to ablation and breakdown of the cable buffer layer.

### SUMMARY

Based on this, the present application provides a water-blocking buffer tape for a cable that does not require the addition of water-blocking powder and does not produce high-resistance crystalline substances. Using the water-blocking buffer tape for the cable can effectively avoid the problem of ablation and breakdown of the cable buffer layer.

Furthermore, the present application provides a method for preparing a water-blocking buffer tape for a cable.

The present application provides a water-blocking buffer tape for a cable, including a rubber substrate and a conductive metal film layer covering a surface of the rubber substrate.

The rubber substrate includes vulcanized butyl rubber and conductive carbon black dispersed in the vulcanized butyl rubber.

In some of the embodiments, the conductive metal film layer has a thickness of 100 nm to 1000 nm.

The present application provides a method for preparing the water-blocking buffer tape for the cable as described in any of the above embodiments, including the following steps:
providing a rubber substrate, the rubber substrate including vulcanized butyl rubber and conductive carbon black dispersed in the vulcanized butyl rubber; and
forming a conductive metal film layer on the rubber substrate.

In some of the embodiments, the rubber substrate is prepared by steps of:
melt blending raw materials of the rubber substrate to form a molten blend; and
crosslinking and compression molding the molten blend to form the rubber substrate; wherein
the raw materials include conductive carbon black, butyl rubber, sulfur, an activator, and a vulcanization aid.

In some of the embodiments, a mass ratio of the butyl rubber to the conductive carbon black is 1: (0.3-0.5).

In some of the embodiments, a mass ratio of the butyl rubber to the sulfur is 1: (0.1-0.2).

In some of the embodiments, the butyl rubber has a Mooney viscosity of 45 Pa·s to 60 Pa·s.

In some of the embodiments, the activator includes at least one of zinc oxide and stearic acid.

In some of the embodiments, the vulcanization aid includes at least one of an antioxidant and a vulcanization accelerator.

In some of the embodiments, the melt blending is performed under conditions including a temperature ranged from 68°C to 72°C and a rotation speed ranged from 45 r/min to 55 r/min.

In some of the embodiments, the crosslinking and compression molding are performed under conditions including a temperature ranged from 165°C to 175°C and a pressure ranged from 12 MPa to 18 MPa.

In some of the embodiments, the conductive metal film layer is deposited on the rubber substrate by magnetron sputtering.

In some of the embodiments, the magnetron sputtering is performed under conditions comprising dual targets as sputtering targets, a sputtering power ranged from 80 W to 120 W, and a sputtering time ranged from 4 min to 6 min.

The present application provides the water-blocking buffer tape for the cable. The rubber substrate includes vulcanized butyl rubber and conductive carbon black dispersed in the vulcanized butyl rubber. The butyl rubber has excellent air tightness, good electrical insulation, good thermal stability and chemical stability, and has good waterproofness and corrosion resistance when utilized in high-voltage cable materials, thereby can replacing the conventional old-fashioned water-blocking buffer materials that require the addition of water-blocking powder. The conductive carbon black is evenly distributed in the rubber substrate to play a conductive role. Moreover, in the water-blocking buffer tape for the cable provided in the present application, the surface of the rubber substrate is covered with the conductive metal film layer, which greatly reduces the volume resistivity of the rubber substrate and greatly improves the conductive performance of the rubber substrate, so that the water-blocking buffer tape for the cable can be in good contact with the outer metal sheath, thereby making the electric field uniform, preventing the cable from local ablation and breakdown, and improving the safety of the high-voltage cable.

### BRIEF DESCRIPTION OF THE DRAWINGS

FIG. 1 is a scanning electron microscope (SEM) image showing the surface morphology of a rubber substrate in Example 1.
FIG. 2 is a scanning electron microscope (SEM) image showing the surface morphology of a water-blocking buffer tape for a cable obtained after sputtering a conductive metal film layer on the surface of the rubber substrate in Example 1.
FIG. 3 is a scanning electron microscope (SEM) image showing the cross-sectional morphology of the rubber substrate in Example 1.
FIG. 4 is a scanning electron microscope (SEM) image showing the cross-sectional morphology of the water-blocking buffer tape for the cable obtained after sputtering the conductive metal film layer on the surface of the rubber substrate in Example 1.
FIG. 5 is a test result diagram of the volume resistivity of the water-blocking buffer tapes for the cables prepared in Example 1 and Comparative Example 1 as a function of temperature.

### DETAILED DESCRIPTION

For ease of understanding of the present application, the present application will be described more fully below in conjunction with embodiments. However, the present application can be implemented in many different forms and is not limited to the embodiments described in the present application. On the contrary, the purpose of providing these embodiments is to make the understanding of the disclosure of the present application more thorough and comprehensive.

Unless otherwise defined, all technical and scientific terms used herein have the same meaning as commonly understood by one of ordinary skill in the art to which the present application belongs. The terms used in the description of the present application are merely used for describing specific embodiments, and are not intended to limit the present application.

In the present application, the terms "and/or", "or/and", "as well as/or" when used in a list of two or more associated items, mean that any one of the items can be selected, and any or all combinations of the items can be selected. The any or all combinations include the combination of any two of the associated listed items, the combination of any more of the associated listed items, or the combination of all associated listed items. It is to be noted that when connecting at least three items with a combination of at least two conjunctions selected from "and/or", "or/and", and "as well as/or", it is to be understood that the technical solution undoubtedly includes all technical solutions that are connected by "logical AND" and also undoubtedly includes all technical solutions that are connected by "logical OR". For example, "A and/or B" includes three parallel solutions: A, B, and A+B. For another example, "A, and/or, B, and/or, C, and/or, D" includes any one of A, B, C, and D (i.e., technical solutions connected by "logical OR"), and any and all combinations of A, B, C, D, such as the combinations of any two or three of A, B, C, and D and the combination of A, B, C, and D (i.e., a technical solution connected by "logical AND").

In the present application, among the technical features described in an open-ended manner, a closed technical solution comprising the enumerated features is included, and an open-ended technical solution comprising the enumerated features is also included.

In addition, the terms "first" and "second" are only used for descriptive purposes, and cannot be understood as indicating or implying relative importance or implicitly indicating the number of indicated technical features. Therefore, the features defined with "first" and "second" may explicitly or implicitly include at least one of the features. In the description of the present disclosure, "a plurality of means at least two, such as two, three, etc., unless specifically defined otherwise.

In the present application, terms such as "preferred", "preferably", "better", and "appropriate" are only used to describe an embodiment or an example with better effect, and should not be construed as constituting a limitation on the protection scope of the present application.

In the present application, terms such as "further", "furthermore", and "especially" are used for descriptive purposes and indicating differences in content, and should not be construed as constituting a limitation on the protection scope of the present application.

In the present invention, the expressions "optionally", and "optional" mean that the subject modified by the expressions is dispensable, that is, the parallel technical solutions "with" or "without" the subject modified by the expressions can both be selected. If the expression "optionally" appears multiple times in a technical solution, unless otherwise specifically stated and without any contradictions or mutually restrictive relationships, the expression "optionally" is independent in each occurrence.

In the present application, for numerical intervals (i.e., ranges of values), unless otherwise specifically stated, the selectable numerical values are considered to be distributed continuously within the numerical intervals and include the two numerical endpoints (i.e., the minimum value and the maximum value) of the range of numerical values, as well as each of the numerical values between these two numerical endpoints. Unless otherwise specified, when the numerical range is directed only to integers within that numerical range, the two endpoint integers of that numerical range are included, as well as each integer between the two endpoints. Herein, it is equivalent to directly listing each integer, for example, t is an integer selected from 1 to 10, which means that t is any integer selected from the integer group consisting of 1, 2, 3, 4, 5, 6, 7, 8, 9 and 10. In addition, when multiple ranges are provided to describe the feature or characteristic, the ranges may be combined. In other words, unless otherwise indicated, the ranges disclosed herein should be construed as including any and all sub-ranges subsumed therein.

The weight of the relevant components mentioned in the embodiments in the description of the present application can not only refer to the specific content of each component, but also represent a proportional relationship between the weights of the components. Therefore, as long as the contents of the relevant components are proportionally enlarged or reduced according to the embodiments in the description of the present application, they are all within the scope disclosed in the embodiments in the description of the present application. Specifically, the weight described in the embodiments in the description of the present application may be a mass unit known in the chemical field, such as µg, mg, g, and kg.

In the present application, unless otherwise specifically defined, the temperature parameters allow for both constant temperature treatment and treatment within a certain temperature range. It is understood that the constant temperature treatment allows for fluctuations within the precision range of the instrument, for example, allows for fluctuations within a range such as ±5°C, ±4°C, ±3°C, ±2°C, and ±1°C.

The buffer layer of the high-voltage cable needs to include a water-blocking buffer tape for water-blocking and waterproofing. However, the old-fashioned water-blocking buffer tape adopts a structure of non-woven fabric added with water-blocking powder. After absorbing moisture, the water-blocking powder easily forms a white powder at the place where it contacts the cable aluminum sheath. The white powder will undergo electrochemical corrosion or electrolysis with the corrugated aluminum in outer layer under the action of an external electric field. Moreover, the white powder includes Al₂O₃, Na₂CO₃, and NaHCO₃, which have high resistance and thus are not conducive to the conduction of the cable and may even generate heat, causing temperature rise and leading to breakdown of the cable.

The present inventors have found through research that the water-blocking buffer tape for the cable made of butyl rubber as the substrate is expected to replace the conventional old-fashioned water-blocking buffer tape made of non-woven fabric added with water-blocking powder and overcome the problem that the water-blocking powder of the old-fashioned water-blocking buffer tape forms white powder after absorbing moisture.

Butyl rubber (IIR) appeared in the 1940s and was industrialized by Exxon Company, USA in 1943. In 1982, the equipment for producing butyl rubber by solution polymerization method appeared in the world, and its polymerization reactor was jointly developed by Rubber Research Institute, USSR, and PI Company, Italy.

Butyl rubber (IIR), the fourth largest synthetic rubber type, is a copolymer obtained by cationic polymerization of isobutylene and a small amount of isoprene. The molecular structure of butyl rubber is a regular linear structure wherein the isoprene chain links account for only 0.6% to 3% in mass fraction. In the main chain of butyl rubber, almost every chain link is tightly surrounded by two methyl groups, resulting in a tight molecular structure, which limits the thermal motion of the macromolecules, and thus renders the butyl rubber with excellent air tightness. Also, butyl rubber has good thermal and chemical stability due to its small double bond content and thus having almost saturated main chains. Butyl rubber also has good electrical insulation properties, low water absorption, heat resistance, aging resistance, and ozone resistance, and thus is suitable for various electrical insulation materials and sealing materials, especially low-hardness sealing materials. Butyl rubber can absorb a large amount of kinetic energy and has excellent weather resistance and water resistance, and thus is an ideal flexible shock-absorbing and buffering material, which is very suitable for manufacturing buffer devices such as dock fenders. Butyl rubber can also be used to produce rubber products such as tapes, hoses, adhesives, and waterproof rolls.

Butyl rubber can further be used as a good substrate of the water-blocking buffer tape for the cable due to its excellent air tightness, electrical insulation, thermal stability, chemical stability, waterproofness, and corrosion resistance.

However, the present inventors found that although butyl rubber has good waterproof and corrosion resistance, the water-blocking buffer tape for the cable made of the conventional butyl rubber has a relatively high volume resistivity. When the water-blocking buffer tape for the cable comes into contact with the outer metal sheath, the heat generated can easily cause the surface to burn, and thus the problem of ablation of the high-voltage cable buffer layer cannot be completely overcome.

On this basis, the present application provides a water-blocking buffer tape for a cable, including a rubber substrate and a conductive metal film layer covering a surface of the rubber substrate.

The rubber substrate includes vulcanized butyl rubber and conductive carbon black dispersed in the vulcanized butyl rubber.

According to the water-blocking buffer tape for the cable provided in the present application, the rubber substrate includes vulcanized butyl rubber and conductive carbon black dispersed in the vulcanized butyl rubber. The butyl rubber has excellent air tightness, good electrical insulation, good thermal stability and chemical stability, and has good waterproofness and corrosion resistance when utilized in high-voltage cable materials, thereby can replacing the conventional old-fashioned water-blocking buffer materials that require the addition of water-blocking powder. The conductive carbon black is evenly distributed in the rubber substrate to play a conductive role. Moreover, in the water-blocking buffer tape for the cable provided in the present application, the surface of the rubber substrate is covered with the conductive metal film layer which has good conductivity. The presence of the conductive metal film layer greatly reduces the volume resistivity of the water-blocking buffer tape for the cable and greatly improves the conductive performance of the water-blocking buffer tape for the cable. The water-blocking buffer tape for the cable can be in good and tight contact with the outer metal sheath with no air space generated, making the electric field distributed uniform, which is in favor of preventing the cable from local ablation and breakdown and improves the safety of the high-voltage cable.

In some of the embodiments, the conductive metal film layer has a thickness of 100 nm to 1000 nm. Within the above thickness range, the conductive metal film layer can greatly reduce the volume resistivity of the rubber substrate, so that the water-blocking buffer tape for the cable has good conductivity, and can be used in an appropriate amount, avoiding excessive thickness and a substantial increase in raw material costs. It can be understood that the thickness of the conductive metal film layer can be, for example, 100 nm, 200 nm, 300 nm, 400 nm, 500 nm, 600 nm, 700 nm, 800 nm, 900 nm, 1000 nm, etc., but not limited thereto. Preferably, the thickness of the conductive metal film layer is 100 nm to 500 nm.

In some of the embodiments, the material of the conductive metal in the conductive metal film layer is silver, copper, aluminum, or the like. Preferably, the conductive metal film layer is a silver film layer.

The present application provides a method for preparing the water-blocking buffer tape for the cable as described in any of the above embodiments, including the following steps:
providing a rubber substrate, the rubber substrate including vulcanized butyl rubber and conductive carbon black dispersed in the vulcanized butyl rubber; and
forming a conductive metal film layer on the rubber substrate.

In some of the embodiments, the rubber substrate is prepared by steps of:
melt blending raw materials of the rubber substrate to form a molten blend; and
crosslinking and compression molding the molten blend to form the rubber substrate; wherein
the raw materials include conductive carbon black, butyl rubber, sulfur, an activator, and a vulcanization aid.

In some of the embodiments, a mass ratio of the butyl rubber to the conductive carbon black is 1: (0.3-0.5). Within the above mass ratio range, the conductive carbon black can be uniformly distributed in the butyl rubber, so that the rubber substrate can not only have good water-blocking property, but also have good electrical conductivity. Preferably, the mass ratio of the butyl rubber to the conductive carbon black can be, for example, 1: 0.30, 1: 0.31, 1 : 0.32, 1: 0.33, 1: 0.34, 1: 0.35, 1: 0.40, 1: 0.45, 1: 0.50, etc., but not limited thereto. Preferably, the mass ratio of the butyl rubber to the conductive carbon black is 1: 0.30.

In some of the embodiments, a mass ratio of the butyl rubber to the sulfur is 1: (0.1-0.2). Within the above mass ratio range, the butyl rubber can be fully cross-linked and vulcanized with sulfur.

In some of the embodiments, the butyl rubber has a Mooney viscosity of 45 Pa s to 60 Pa·s.

In some of the embodiments, the activator includes at least one of zinc oxide and stearic acid.

In some of the embodiments, the vulcanization aid includes at least one of an antioxidant and a vulcanization accelerator. Further, the antioxidant may be, for example, antioxidant 4010, paraffin, etc., but not limited thereto. Further, the vulcanization accelerator may be, for example, vulcanization accelerator M, vulcanization accelerator TMTD, etc., but not limited thereto.

In some of the embodiments, the melt blending is performed under conditions including a temperature of 68°C to 72°C and a rotation speed of 45 r/min to 55 r/min. It can be understood that the temperature for the melt blending can be 68°C, 69°C, 70°C, 71°C, 72°C, etc., but not limited thereto, and the rotation speed can be 45 r/min, 46 r/min, 47 r/min, 49 r/min, 50 r/min, 53 r/min, 55 r/min, etc., but not limited thereto. Preferably, the temperature is 70°C and the rotation speed is 50 r/min.

In some of the embodiments, the crosslinking and compression molding are performed under conditions including a temperature of 165°C to 175°C and a pressure of 12 MPa to 18 MPa. It can be understood that for the crosslinking and compression molding, the temperature can be, for example, 165°C, 168°C, 169°C, 170°C, 171°C, 172°C, 175°C, etc., but not limited thereto, and the pressure can be 12 MPa, 13 MPa, 14 MPa, 15 MPa, 16 MPa, 17 MPa, 18 MPa, etc., but not limited thereto. Preferably, the temperature is 170°C and the pressure is 15 MPa.

In some of the embodiments, the conductive metal film layer is deposited on the rubber substrate by magnetron sputtering. By magnetron sputtering, the conductive metal film layer can be tightly coated on the surface of the rubber substrate continuously and uniformly. It can be understood that in other embodiments, the conductive metal film layer can be formed on the rubber substrate by other methods, as long as it can ensure that the conductive metal film layer is tightly combined with the rubber substrate and is not easy to fall off. The magnetron sputtering is simple to operate, mature in technology, and has strong scalability and operability.

In some of the embodiments, the magnetron sputtering is performed under conditions including dual targets as sputtering targets, a sputtering power ranged from 80 W to 120 W, and a sputtering time ranged from 4 min to 6 min. It can be understood that the sputtering power can be 80 W, 90 W, 100 W, 110 W, 120 W, etc., but not limited thereto, and the sputtering time can be 4 min, 5 min, 6 min, etc., but not limited thereto. Preferably, the sputtering power is 100 W and the sputtering time is 5 min.

The present application is further described in detail below through specific examples. The descriptions in the following embodiments are relatively specific, and it is understood that other embodiments are not limited to thereto. Unless otherwise specified, the instruments, reagents, materials, and the like involved in the following specific examples are all conventional instruments, reagents, and materials known in the prior art and can be commercially available. Unless otherwise specified, the experimental methods, detection methods, and the like involved in the following examples are all conventional experimental methods, and detection methods known in the prior art.

Butyl rubber is from Japan JSR268, and has a Mooney viscosity of 45 Pa·s to 56Pa·s.

### Example 1

A method for preparing a water-blocking buffer tape for a cable includes the following steps:

100 g of butyl rubber was put into an internal mixer while maintaining the temperature of the internal mixer at 70°C and the rotation speed at 50 r/min. After 3 minutes, 5 g of ZnO and 2 g of stearic acid were added to the internal mixer. After 3 minutes, 21.5 g of conductive carbon black (half of the total conductive carbon black mass) was added to the internal mixer, and after additional 2 minutes, 21.5 g of conductive carbon black (the other half of the total conductive carbon black mass) was added to the internal mixer. The mixture was mixed for additional 3 minutes to completely disperse the conductive carbon black. Then 2 g of antioxidant 4010 and 0.6 g of paraffin were added to the internal mixer, and mixed for 3 minutes. Next, the mixture was removed from the internal mixer, forming a first molten blend. The first molten blend was left in a room temperature environment for cooling for 8 hours, then put again into the internal mixer where the temperature was maintained at 70°C and the rotation speed was maintained at 50 r/min. After 3 minutes, 15 g of sulfur, 0.5 g of vulcanization accelerator M, and 1 g of vulcanization accelerator TMTD were added and mixed for 3 minutes. Then, the mixture was removed from the internal mixer and cooled, forming a second molten blend. The second molten blend was melted by a flat vulcanizer at 70°C, and crosslinked and compression molded at 170°C and 15 MPa to form a rubber substrate with a thickness of 1 mm. After cooling, a continuous conductive metal film layer was sputtered onto the surface of the rubber substrate using a dual target magnetron sputtering equipment. The magnetron sputtering power was 100 W, the sputtering time was 5 minutes, the sputtering thickness was about 100 nm, and the conductive metal material was silver. Once the sputtering was uniformly performed, the sputtered rubber substrate was taken out, thereby forming the water-blocking buffer tape for the cable.

### Comparative Example 1

Comparative Example 1 was substantially the same as Example 1, except that no conductive metal film layer was sputtered.

A method for preparing a water-blocking buffer tape for a cable includes the following steps:
100 g of butyl rubber was put into an internal mixer while maintaining the temperature of the internal mixer at 70°C and the rotation speed at 50 r/min. After 3 minutes, 5 g of ZnO and 2 g of stearic acid were added to the internal mixer. After 3 minutes, 21.5 g of conductive carbon black (half of the total conductive carbon black mass) was added to the internal mixer, and after additional 2 minutes, 21.5 g of conductive carbon black (the other half of the total conductive carbon black mass) was added to the internal mixer. The mixture was mixed for additional 3 minutes to completely disperse the conductive carbon black. Then 2 g of antioxidant 4010 and 0.6 g of paraffin were added to the internal mixer, and mixed for 3 minutes. Next, the mixture was removed from the internal mixer, forming a first molten blend. The first molten blend was left in a room temperature environment for cooling for 8 hours, then put again into the internal mixer where the temperature was maintained at 70°C and the rotation speed was maintained at 50 r/min. After 3 minutes, 15 g of sulfur, 0.5 g of vulcanization accelerator M and 1 g of vulcanization accelerator TMTD were added and mixed for 3 minutes. Then, the mixture was removed from the internal mixer and cooled, forming a second molten blend. The second molten blend was melted by a flat vulcanizer at 70°C, and crosslinked and compression molded at 170°C and 15 MPa to form a rubber substrate with a thickness of 1 mm. After cooling, the rubber substrate was regarded as the water-blocking buffer tape for the cable.

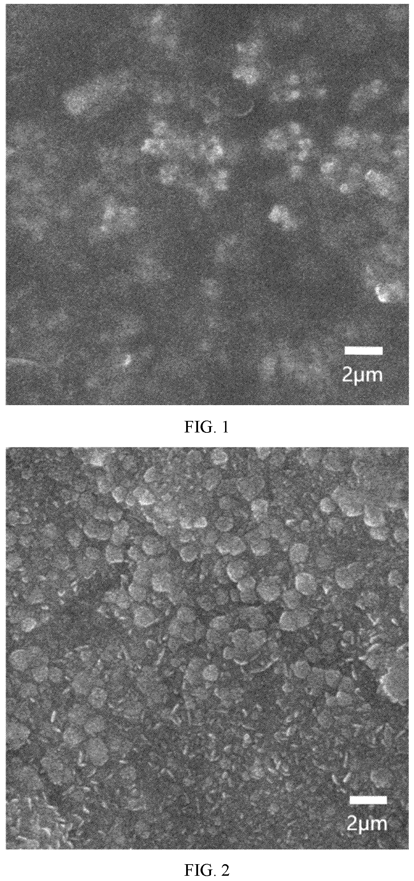

The surface morphologies of the rubber substrate prepared in Example 1 and the water-blocking buffer tape for the cable prepared after sputtering the conductive metal film layer were compared by SEM scanning using a scanning electron microscope. The SEM scanning results are shown in FIGS. 1 and 2. It can be seen from FIG. 1 that the surface of the rubber substrate obtained by compression molding was smooth without obvious interfaces, and the conductive carbon black inside was evenly distributed and formed a grape-like conductive path. It can be clearly seen from FIG. 2 that the nanosilver particles were evenly sputtered onto the surface of the rubber substrate, forming a uniform conductive metal film layer.

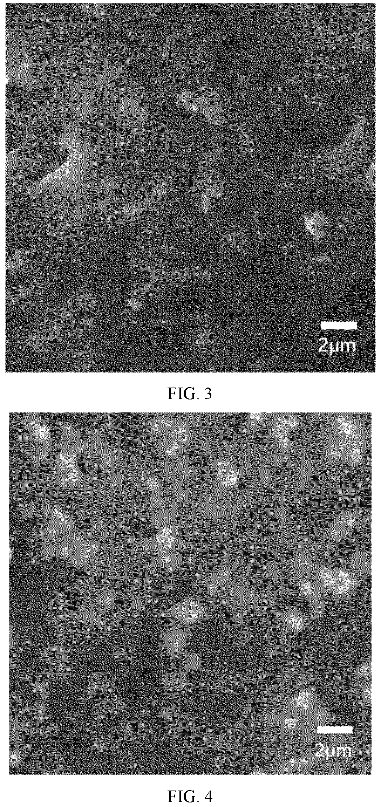

The cross-sectional morphologies of the rubber substrate prepared in Example 1 and the water-blocking buffer tape for the cable prepared after sputtering the conductive metal film layer were compared by SEM scanning using a scanning electron microscope. The SEM scanning results are shown in FIGS. 3 and 4. It can be seen from FIGS. 3 and 4 that, the conductive carbon black inside the rubber substrate was uniformly and continuously distributed without obvious changes before and after magnetron sputtering, indicating that magnetron sputtering has no adverse effect on the uniform distribution of the conductive carbon black.

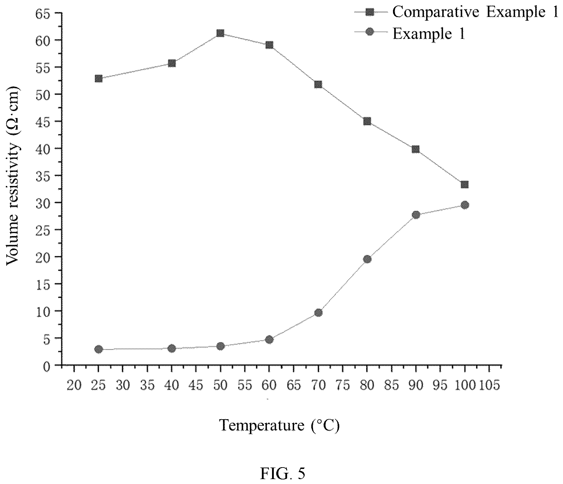

The water-blocking buffer tapes for the cables prepared in Example 1 and Comparative Example 1 were tested for volume resistivity as a function of temperature. The test results are shown in FIG. 5. It can be seen that at room temperature, the volume resistivity of the water-blocking buffer tape for the cable of Example 1 was significantly lower than that of the water-blocking buffer tape for the cable of Comparative Example 1, indicating that the water-blocking buffer tape for the cable of Example 1 has more superior conductive performance and can better contact with the outer metal sheath, thereby making the electric field uniform, preventing the cable from local ablation and breakdown and improving the safety of the high-voltage cable.

Five samples of each of the water-blocking buffer tapes for cables prepared in Example 1 and Comparative Example 1 were tested for tensile strength. The test results showed that the average tensile strength was 10 MPa for Example 1, and 10.44 MPa for Comparative Example 1. It can be seen that the tensile strength of the material was rarely affected before and after magnetron sputtering the conductive metal film layer, indicating that the sputtering method will not change the original blending structure of the rubber and the conductive carbon black inside the rubber substrate.

Five samples of each of the water-blocking buffer tapes for the cables prepared in Example 1 and Comparative Example 1 were tested for elongation at break. The test results showed that the average elongation at break was 658.03% for Example 1, and 667.9% for Comparative Example 1. It can be seen that the elongation at break of the material was rarely affected before and after magnetron sputtering the conductive metal film layer, indicating that the water-blocking buffer tape for the cable still has good mechanical properties after magnetron sputtering the conductive metal film layer.

## Claims

1. A water-blocking buffer tape for a cable, comprising a rubber substrate and a conductive metal film layer covering a surface of the rubber substrate; wherein
the rubber substrate comprises vulcanized butyl rubber and conductive carbon black dispersed in the vulcanized butyl rubber.

2. The water-blocking buffer tape for the cable according to claim 1, wherein the conductive metal film layer has a thickness of 100 nm to 1000 nm, preferably the thickness of the conductive metal film layer is 100 nm to 500 nm;
optionally, a material of the conductive metal in the conductive metal film layer comprises silver, copper, or aluminum, preferably silver.

3. A method for preparing the water-blocking buffer tape for the cable according to claim 1 or 2, comprising the following steps:
providing a rubber substrate, the rubber substrate comprising vulcanized butyl rubber and conductive carbon black dispersed in the vulcanized butyl rubber; and
forming a conductive metal film layer on the rubber substrate.

4. The method according to claim 3, wherein the rubber substrate is prepared by steps of:
melt blending raw materials of the rubber substrate to form a molten blend; and
crosslinking and compression molding the molten blend to form the rubber substrate; wherein
the raw materials comprise conductive carbon black, butyl rubber, sulfur, an activator, and a vulcanization aid.

5. The method according to claim 4, wherein a mass ratio of the butyl rubber to the conductive carbon black is 1: (0.3-0.5), preferably 1: 0.30; and/or
a mass ratio of the butyl rubber to the sulfur is 1: (0.1-0.2); and/or
the butyl rubber has a Mooney viscosity of 45 Pa s to 60 Pa s.

6. The method according to claim 4, wherein the activator comprises at least one of zinc oxide and stearic acid; and/or
the vulcanization aid comprises at least one of an antioxidant and a vulcanization accelerator, optionally, the antioxidant comprises antioxidant 4010 or paraffin;
optionally, the vulcanization accelerator comprises vulcanization accelerator M, or vulcanization accelerator TMTD.

7. The method according to any one of claims 4 to 6, wherein the melt blending is performed under conditions comprising a temperature ranged from 68°C to 72°C and a rotation speed ranged from 45 r/min to 55 r/min, preferably the temperature is 70°C and the rotation speed is 50 r/min.

8. The method according to any one of claims 4 to 6, wherein the crosslinking and compression molding are performed under conditions comprising a temperature ranged from 165°C to 175°C and a pressure ranged from 12 MPa to 18 MPa, preferably the temperature is 170°C and the pressure is 15 MPa.

9. The method according to any one of claims 3 to 6, wherein the conductive metal film layer is deposited on the rubber substrate by magnetron sputtering.

10. The method according to claim 9, wherein the magnetron sputtering is performed under conditions comprising dual targets as sputtering targets, a sputtering power ranged from 80 W to 120 W, and a sputtering time ranged from 4 min to 6 min, preferably the sputtering power is 100 W and the sputtering time is 5 min.
